# EUROPEAN PATENT APPLICATION

(11) **EP 1 594 073 A2**
(43) Date of publication of application: **09.11.2005**
(21) Application number: 05290977.7
(22) Date of filing: 04.05.2005
(51) Int. Cl.: G06F 17/50, G06T 17/40

(54) **Deformation of a computer-aided design model**

(30) Priority: 04.05.2004 US 839033
(71) Applicant: Solidworks Corporation, Concord, MA 01742 (US)
(72) Inventor: Maystrovsky, Gennady David, Brookline Massachusetts 02446 (US); Kwon, Byungwook, Acton Massachusetts 01720 (US); Hu, Chun-Yi, Lexington Massachusetts 02420 (US)
(74) Representative: Hirsch & Associés

(57) **Abstract**

Deforming a three-dimensional target model using a three-dimensional tool model to cause a change of shape of the target model includes selecting the three-dimensional tool model whereby the tool model representing an archetype of a shape to impress upon the three-dimensional target model, and deforming the target model in accordance with a surface deformation procedure that produces a smoothed shape of the tool model in a region of the target model.

## Description

### BACKGROUND OF THE INVENTION

Computer-aided design (CAD) software allows a user to construct and manipulate complex three-dimensional (3D) models, such as surface bodies and solid bodies. A solid or surface body is a collection of interconnected topological entities (e.g., vertices, edges, and faces). The topological entities have corresponding supporting geometrical entities (e.g., points, trimmed curves, and trimmed surfaces). Topological structures may be manifold or non-manifold structures. In the case of manifold topological structures, all edges of a solid body have two adjacent faces (which may coincide), and therefore, a solid body encloses a volume. A surface body has at least one laminar edge (i.e., the edge has only one adjacent face), and thus, a surface body does not enclose a volume. In general, non-manifold topological structures do not differentiate between a solid and a surface body.

CAD systems may combine surface and solid modeling techniques. Additionally, CAD systems may employ other modeling techniques, such as parametric modeling techniques. Parametric modeling techniques allow for the definition of various parameters for the features, allow for references between the features, and allow for the establishment of relationships between those features based on the relationships between the parameters and references of those features.

A designer is a typical user of a 3D CAD system. The designer designs physical and aesthetic aspects of 3D models, and is skilled in 3D modeling techniques. The designer may create parts and may assemble the parts into assemblies.

In many CAD systems, curves and surfaces are generally represented as analytical, Bezier, or spline curves and surfaces, and in particular as non-uniform rational b-spline (NURBS) curves and surfaces. In contrast, some CAD systems and models used only for display purposes (e.g., in the entertainment and medical imaging industries) utilize tessellated models whereby the surfaces of a model are faceted by sub-dividing each surface into triangular or other polygonal shapes.

One feature of many commercially available 3D CAD systems enables a designer to deform a CAD model by modifying one or more surfaces of the CAD model. Several deformation techniques have been implemented by current state of the art 3D CAD systems. Some of these deformation techniques apply to surfaces based on NURBS representations.

The SolidWorks® 2004 software product, available from SolidWorks Corporation of Concord, Massachusetts, can deform one or more surface or solid bodies using point and curve entities as the method of manipulation. Using a point entity involves pushing and pulling a point on a surface, whereas using a curve entity involves pushing and pulling a curve on a surface.

The point and curve deformations as implemented in the SolidWorks software product provide user control over the deformation by enabling the user to specify the area to which the deformation will be applied (e.g., by specifying a radius of influence, by explicitly indicating the faces to deform, or by both the foregoing). The SolidWorks 2004 deformation operations maintain the topology and the smoothness of NURBS bodies that were deformed and can influence more than one surface and body. However, the point and curve deformation operations implemented by SolidWorks 2004, as well as other CAD products, lack a means to employ a surface as an archetype for modifying existing surfaces, which limits the ability to form the desired shape of NURBS bodies that were deformed.

Another surface deformation technique allows for the direct modification of NURBS control points. A set of control points defines the shape of a parametric surface. When a control point is transformed, a local region of the surface is modified. The size of the region that is modified and the surface shape after the deformation depend upon a transformation vector applied to a control point. This technique modifies only one surface at a time, and does not maintain the tangency between the modified surface and the adjacent surfaces.

Another technique for modifying surface and solid bodies uses a solid body tool and is sometimes referred to as functional modeling. The functional modeling technique combines several operations, including Boolean operations. Rather than deforming the geometry of one or more existing surfaces, the functional modeling technique breaks the surfaces of the solid body tool and the surfaces being modified into fragments and assembles the fragments to create a new body with additional faces and new sharp edges. Thus, the topology of the modified solid and surface bodies is changed, and therefore, the functional modeling technique is not well-suited for free-form surface design because the surfaces being modified are broken and sharp edges may be introduced.

Designers need an efficient means to make complex modifications to 3D CAD models. Moreover, the modifications need to affect a large region containing one or more CAD bodies. A 3D CAD system that allows designers to quickly deform one body using another body as a tool without changing the topology of the deformed bodies, no matter how complex the bodies may be nor how many CAD bodies are affected by the deformation, would enhance the capabilities of such a 3D CAD system.

### SUMMARY OF THE INVENTION

In general, in one aspect, the invention features a computer-implemented method for deforming a target model using a three-dimensional tool model to cause the shape of the target model to change. The method includes selecting the three-dimensional tool model. The tool model represents an archetype of the shape to impress upon the three-dimensional target model. The target model is then deformed in accordance with a surface deformation procedure that produces a smoothed shape of the tool model in the region of the target model.

Implementations may include indicating a push direction for detecting a set of extreme geometric values, examining geometric values utilized to construct the tool model and geometric values utilized to construct the target model, and generating the set of extreme geometric values. Each one of the extreme geometric values is either a geometric value utilized to construct the tool model or a geometric value utilized to construct the target model, whichever represents a point furthest along an axis extending in the push direction. A surface of extreme values is constructed from the set of extreme geometric values and is smoothed to create a smoothed surface.

Implementations may include one or more of the following features. The target model has the same number of faces and edges before and after the deformation. A smoothness value can be specified that indicates the size of a region of the surface of extreme values, and may be a default or user-specified value. The smoothed surface can be converted to a non-uniform rational b-spline formulation. The tool body and the target body can each consist of one or more curve, solid, and surface bodies. The tool model can be moved by applying a transformation, and the direction of the tool body movement can define the push direction. Implementations may also include interactively receiving user input, determining the transformation to apply to the tool model in accordance with the user input, and displaying the current view of the three-dimensional target model while deformation of the target model is shown as the transformation is applied.

The details of one or more embodiments of the invention are set forth in the accompanying drawings and the description that follows. Other features, objects, and advantages of the invention will be apparent from the description and drawings, and from the claims.

### DESCRIPTION OF THE DRAWINGS

FIG. 1 is an illustration of a model displayed in a window.
FIG. 2A is an illustration of a target body and a tool body.
FIG. 2B is an illustration of a target body and a tool body.
FIG. 2C is an illustration of a result that may occur using a functional modeling technique.
FIG. 3 is a flowchart of a procedure that deforms one or more target bodies.
FIG. 4 is a flowchart of procedure that deforms one or more target bodies.
FIG. 5A is an illustration of a target body and a tool body.
FIG. 5B is an illustration of a surface of extreme values.
FIG. 5C is an illustration of a smooth surface.
FIG. 6A is an illustration of a bracket.
FIG. 6B is an illustration of a bracket and a tool body.
FIG. 6C is an illustration of a deformed bracket.
FIG. 7A is an illustration of a target body and three tool bodies.
FIG. 7B is an illustration of a deformed target body and three tool bodies.
FIG. 8A is an illustration of a target body.
FIG. 8B is an illustration of a target body and a tool body.
FIG. 8C is an illustration of a deformed target body.
FIG. 8D is an illustration of a deformed target body.
FIG. 9 is a diagram of a computer system.

### DETAILED DESCRIPTION OF THE INVENTION

The present invention facilitates the deformation of three-dimensional (3D) curve, surface, and solid bodies by a computer-aided design (CAD) system. One or more curve, surface, or solid bodies are selected for the purpose of deforming the shape of one or more other curve, surface, or solid bodies. The deformation is achieved without modifying the topology of the bodies being deformed. Moreover, the existing tangency and curvature continuity between the surfaces of each body being deformed is preserved. By allowing a model to be deformed while preserving the topology as well as the existing tangency and curvature continuity of the bodies targeted for deformation, the present invention enhances the flexibility and functionality of a computerized modeling system.

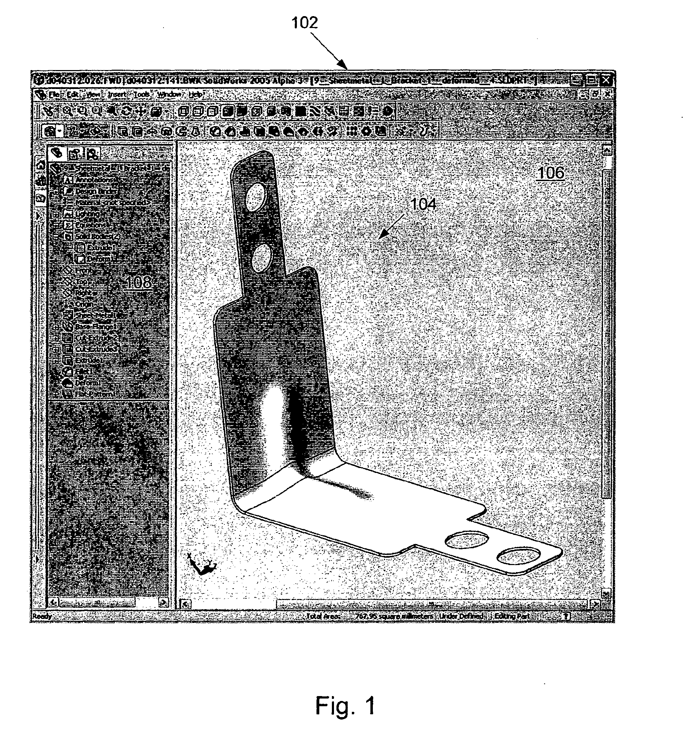

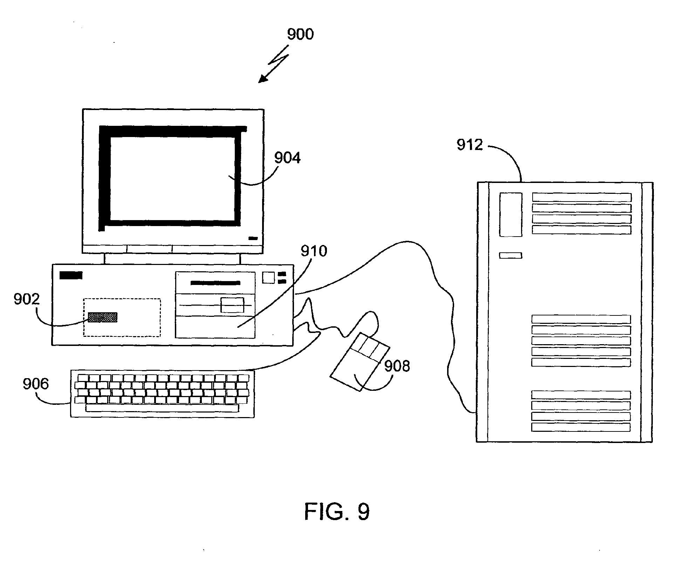

FIG. 1 shows a window 102 displayed on the CRT and generated by CAD modeling software executed by a computerized modeling system, an example of which is later shown with reference to FIG. 9. The window 102 is a conventional computer-generated window that can be programmed by one of ordinary skill in the art using conventional, commercially available, software programming tools, such as those available from Microsoft Corporation of Redmond, Washington.

A computer-generated 3D model 104 is displayed within a modeling portion 106 of the window 102. A designer can construct and modify the 3D model 104 in a conventional manner. The surfaces of the 3D model 104 can be displayed, or the 3D model 104 can be displayed using solid lines and dashed lines to show visible edges and hidden edges, respectively, of the 3D model 104. Implementations also may include other window areas, such as a list of features 108, which helps the designer visualize and manipulate the 3D model 104 shown in the modeling portion 106.

In one embodiment, the modeling system is a solid modeling system that may be used to model curve, surface, and solid bodies, and assemblies thereof. The topological structures of the bodies may be manifold or non-manifold structures. The 3D model 104 shown in FIG. 1 is a model of a part; however, a 3D model may be an assembly of parts, where each part is comprised of topological entities such as vertices, edges, and faces, and geometric entities such as points, curves, and surfaces. Curves and surfaces may be analytical (e.g., lines, arcs, planes, and cylinders), represented as a Bezier structure, or represented as splines, such as non-uniform rational b-splines, which is a standard curve and surface representation used throughout the CAD industry. Hereinafter, the term non-uniform rational b-spline will be referred to by the acronym NURBS. Generally, the curves and surfaces can be any curve or surface that can be evaluated, including tessellated surfaces and subdivided surfaces.

The present invention deforms one or more bodies targeted for deformation and hereinafter referred to as a target bodies. The target bodies are influenced by one or more other bodies, hereinafter referred to as a tool bodies. After deformation, the shapes of the surfaces of the target bodies in the contact regions of the tool bodies will be analogous to the shape of the surfaces of the tool bodies. The shapes of the surfaces in the contact regions of the target bodies are not completely identical to the shape of the surfaces of the tool bodies because sharp edges in the contact regions of the target bodies are intentionally smoothed, which will later be discussed. The present invention is not limited to particular geometric representations of the target and tool bodies, and allows for representing the resulting deformed target bodies as NURBS surfaces, if desirable.

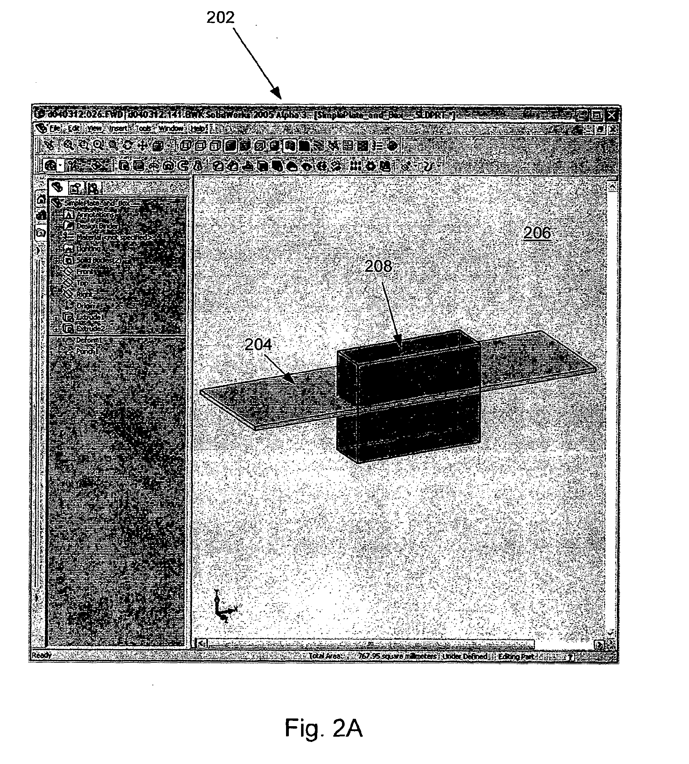

Referring now to FIG. 2A, the window 202 contains a 3D model, which is a target body 204 displayed within the modeling portion 206 of the window 202. To deform the target body 204, the designer selects a tool body 208. The tool body 208 is an archetype of a shape the target body 204 will assume after deformation. For the purpose of simplifying this discussion, only one target body and one tool body are illustrated and both bodies are cuboids.

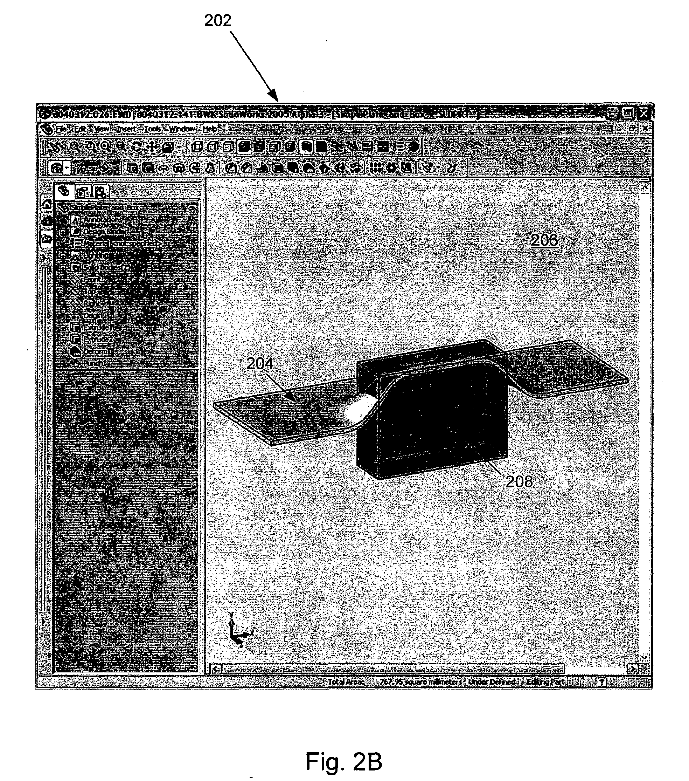

FIG. 2B illustrates the affect the present invention has on the target body 204. The present invention applies a surface-to-surface deformation procedure. That is, the geometry of the tool body 208 surfaces acts upon the geometry of the target body 204 surfaces in such a way as to deform the target body 204 surfaces. The present invention implements a deformation procedure that approximates the shape of the tool body 208 in the region of the deformation rather than constructing an exact representation of the tool body 208, thereby preserving the smoothness of the modified surfaces by not introducing any sharp edges in the target body 204.

As shown in FIG. 2B, the present invention preserves the topology of the target body 204. In particular, the number of faces and the number of edges of the target body 204 are unchanged. That is, the same six faces and twelve edges, and no more, are present in the target body 204 after the deformation process as were present before the deformation process. Furthermore, all surfaces of the target body 204 remain smooth after the deformation completes, as is noticeable by the absence of new sharp edges in the target body 204.

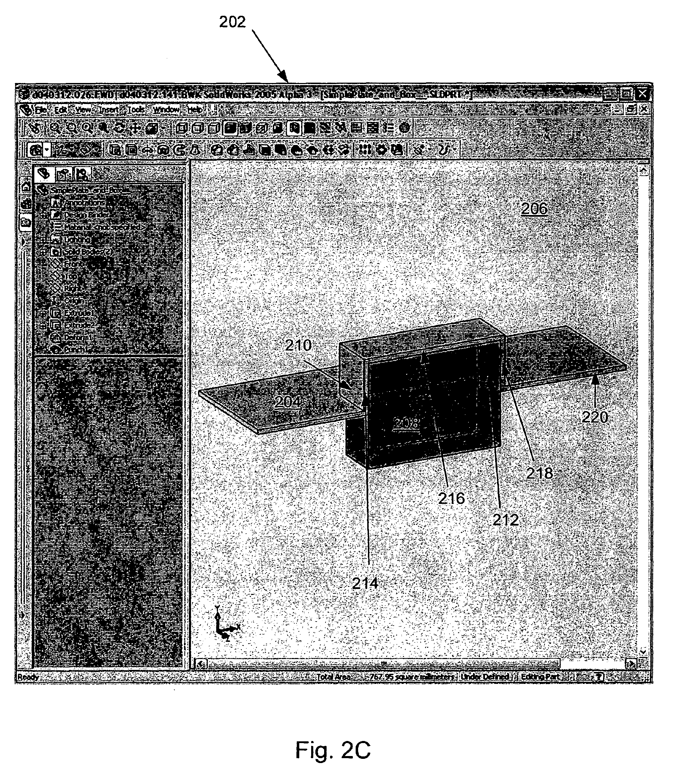

FIG. 2C illustrates an outcome that the present invention avoids after a deformation operation has applied the tool body 208 to the target body 204. As shown in FIG. 2C, the target body 204 acquired additional faces 210-220, as well as additional other faces that are not shown in FIG. 2C due to the orientation of the target body 204 and the tool body 208. Thus, the topology of the target body 204 has been modified. Breaking existing faces and surfaces into several faces and surfaces introduces sharp edges between the newly created faces and surfaces.

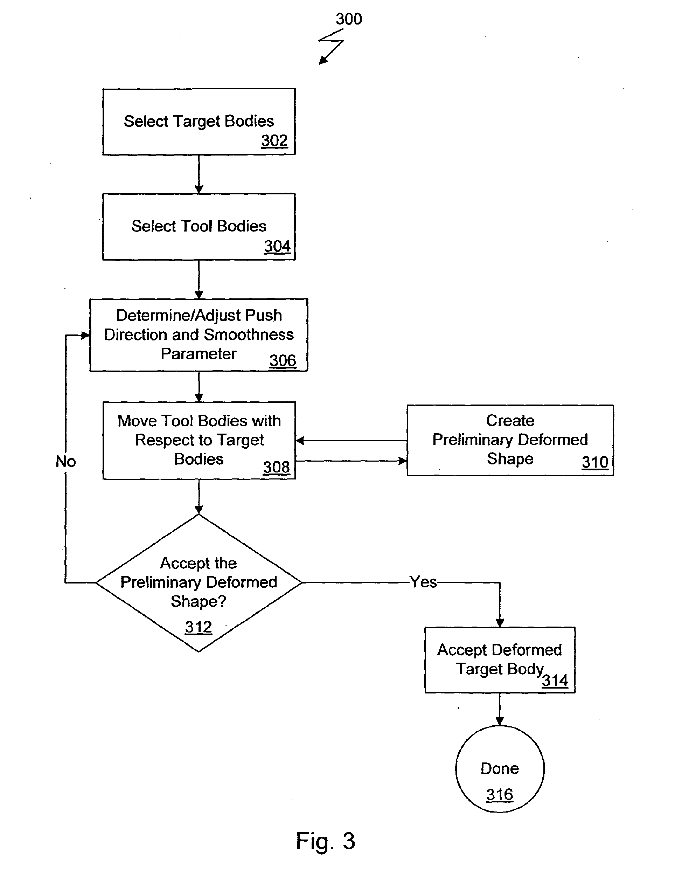

FIG. 3 is a flowchart of a procedure 300 that deforms one or more target bodies using one or more tool bodies. First, one or more target bodies are selected (step 302). The target bodies may be constructed using functionality available in a state of the art 3D CAD system. Moreover, the state of the art 3D CAD system may be a system other than that which contains an implementation of the present invention, in which case, the target bodies may be imported into a 3D CAD system that does contain an implementation of the present invention. In addition, the target bodies must be internally represented in a data structure as a curve body, a surface body, a solid body, or combination thereof. (A wire-frame body is used as an industrial term for a curve body.)

In the next step, one or more tool bodies are selected (step 304). The tool bodies may also be constructed using functionality available in a state of the art 3D CAD system, and may be constructed in one 3D CAD system and imported into another 3D CAD system that contains an implementation of the present invention. Furthermore, the tool bodies may be constructed for the specific purpose of being used as a tool for deforming another body, or may be constructed for another purpose and then used as a deformation tool. An example of the latter is that a model of an object may also serve as a tool body for creating a model of a package for the object.

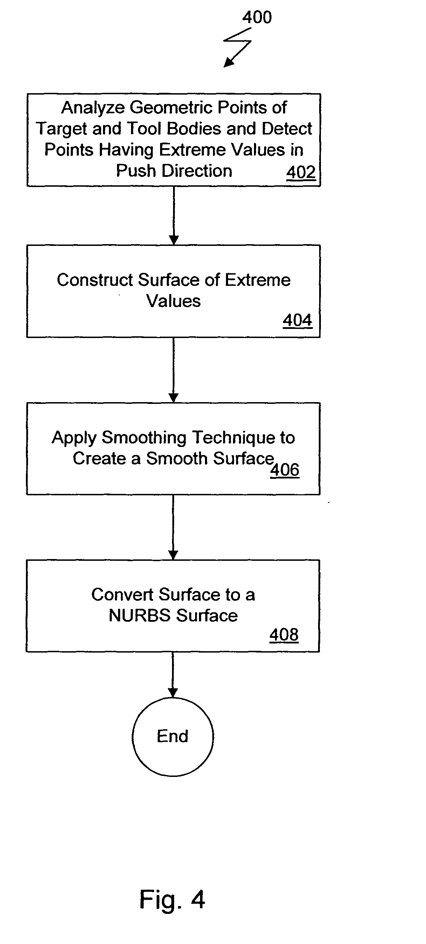

In the next step, the push direction and smoothness parameter are determined (step 306). The push direction and smoothness parameter may be system- or user-defined. The push direction is used to analyze the geometric points of the tool and target bodies when creating a deformed shape and is further discussed with reference to FIG. 4. The smoothness parameter is visibly analogous to a fillet radius. The smoothness parameter specifies the extent of the surrounding region used by a smoothing operation and determines the minimum radius of curvature of the deformed surfaces, which will later be discussed.

The tool bodies are then moved with respect to the target bodies (step 308). Procedure 300 allows the tool bodies to influence the target bodies in such a way as to deform the target bodies when the tool and target bodies are proximate to one another. The extent of influence depends on the position of the surfaces of the tool bodies relative to the surfaces of the target bodies.

The target bodies are automatically deformed when the tool bodies are moved in any direction. The tool bodies may be moved by applying transformations (e.g., rotation and translation transformations), to the tool bodies in accordance with input data received by the CAD system from an interactive device. By way of non-limiting example, a mouse or other pointing device can be used to drag the tool bodies toward the target bodies and thereby cause the deformation operations discussed herein to be applied to the target bodies.

Alternatively, rather than moving the tool bodies to exert influence on the target bodies, the tool bodies can be positioned where the desired influence will be applied to the target bodies (see FIG. 2A for an illustration of such a position). The CAD system can then be instructed to deform the target bodies while only accounting for the position of the tool bodies having the desired influence.

While the target bodies are being deformed, the present invention can create a preliminary shape of the target bodies (step 310). The preliminary shape can then be presented to the designer, enabling the designer to preview the deformed target bodies, and determine whether to modify the push direction or the smoothness parameter, prior to accepting the deformed target bodies in a final form. The preview capability may be disabled when a CAD system has insufficient resources to continuously deform the target bodies as the tool bodies are moved, meaning that the deformation operations cannot occur interactively in real-time. Moreover, the designer may issue a command to the CAD system to instruct the present invention to display a preview of the target bodies when desired.

The target bodies continue to be deformed and smooth transition shapes continue to be created until the target bodies obtain a form that is acceptable to the designer. The topology, existing tangency, and curvature conditions of the target body are maintained throughout the deformation process.

The designer decides whether to accept the preliminary deformed shape (step 312). The preliminary deformed shape is not accepted if the designer continues to move the tool bodies and thereby, the target bodies continue to be deformed, or if the designer adjusts the push direction or smoothness parameter, before continuing to deform the target bodies. The preliminary deformed shape is accepted when the 3D CAD system is commanded to accept the deformed target bodies as the final shape of the target bodies. To command the system to accept the deformed target bodies as the final shape, the designer may use an interactive device to transmit input data to the 3D CAD system and thereby indicate acceptance. When the deformed target bodies are accepted (step 314), the target bodies assume a final deformed shape and the procedure 300 completes (step 316).

Referring now to FIG. 4, a flowchart of a deformation procedure 400 is shown. The procedure 400 shows step 310 described with reference to FIG. 3 in more detail. The procedure 400 begins by analyzing the geometric points of the target and tool bodies and detecting which points have the extreme values in the push direction (step 402). In one embodiment, the trajectory of the tool bodies is not considered in determining the points having the extreme values, only the current position of the tool bodies is considered. In another embodiment, the trajectory of the tool bodies may be the push direction. The points having the extreme values in the push direction are used to construct a surface of extreme values (step 404), which may not be a smooth surface. In the following step, a smoothing technique is applied to the surface of extreme values to create a smooth surface (step 406).

In general, for each point in the surface of extreme values, the smoothing technique considers an area surrounding the point and computes a weighted average geometric value for that point. By way of non-limiting examples, moving window averaging, two-dimensional Savitzky-Golay filters, and spline estimation are smoothing techniques that may be applied to smooth the surface of extreme values. The smoothness parameter is used as input to the smoothing technique and defines the minimum radius of curvature of the deformed surfaces. The smaller the value of the smoothness parameter, the more similar the deformed surfaces of the target bodies will be to the surfaces of the tool bodies, and the smaller the minimum radius of curvature of the deformed surfaces will be. The greater the smoothness parameter, the greater the minimum radius of curvature of the deformed surfaces will be and the smoother the deformed surface will be. An advantage of using a smoothing technique is that the smoothing technique preserves the preexistent smoothness between adjacent surfaces. If two original surfaces of a target body were tangentially adjacent or curvature continuous adjacent, the surfaces will remain so after the deformation process completes.

In many state-of-the-art CAD systems, surfaces are represented as NURBS surfaces. Therefore, the present invention allows the smoothed surface to be represented as a NURBS surface. Smoothing techniques such as a spline estimation technique do create a NURBS surface (and therefore, the following step 408 is not needed). For smoothing techniques that do not create a NURBS surface, by way of non-limiting example, a surface-fitting procedure may be applied to the smoothed surface to convert the smoothed surface into a NURBS surface (step 408). A number of commercially available products provide software libraries that implement surface-fitting procedures. One such product is Nlib™, available from Solid Modeling Solutions, Inc. of Bellevue, Washington.

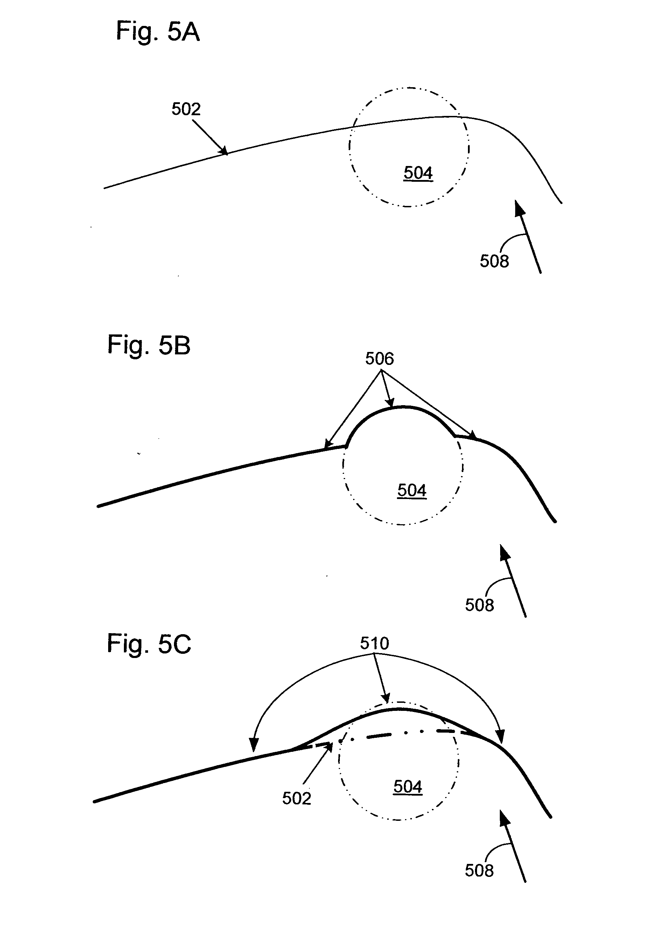

Referring now to FIG. 5A, two-dimensional profiles of a target body 502 and a tool body 504 are shown for the purpose of illustrating procedure 400. The two-dimensional profiles may also be curve bodies. In FIG. 5A, the target body 502 is indicated by a solid line font and the tool body 504 is indicated by a dashed and dotted line font. The push direction 508 indicates the direction in which the points with extreme values will be detected.

FIG. 5B illustrates in bold face font the surface of extreme values 506. As previously discussed, the surface of extreme values is created after analyzing the geometric points of the target body 502 and tool body 504, detecting which points have the extreme values in the push direction, and constructing the surface of extreme values 506 using the points having the extreme values in the push direction.

FIG. 5C illustrates a smoothed surface 510 in bold face font relative to the target body 502 and the tool body 504. The smoothed surface 510 may be a NURBS surface, and if not, the smoothed surface 510 may be converted into a NURBS surface.

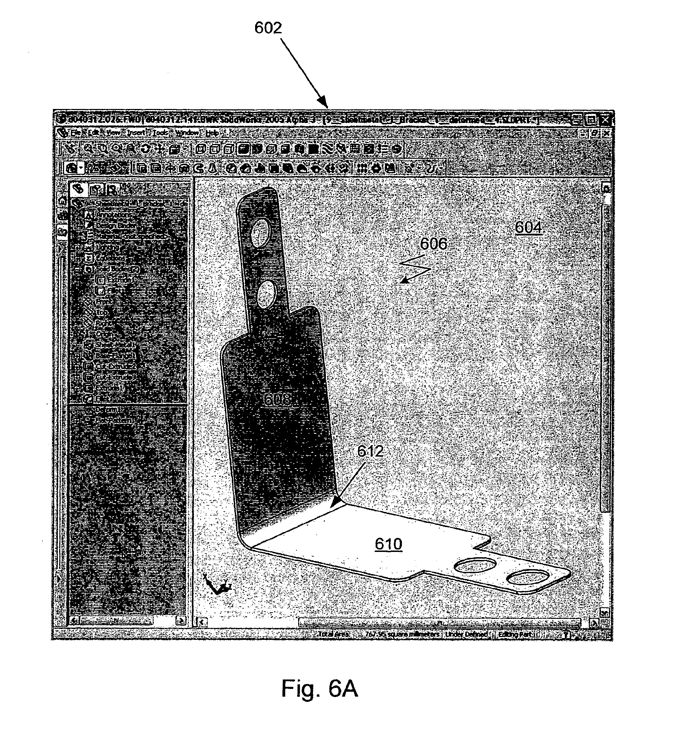

Referring to FIG. 6A, a bracket 606 is shown in a modeling portion 604 of a window 602. The bracket has a vertical side 608 and a horizontal side 610, which are formed into one part using a bend 612. The bracket 606 is comprised of numerous surfaces, which may be analytical, Bezier, or NURBS surfaces, or any surface that can be evaluated.

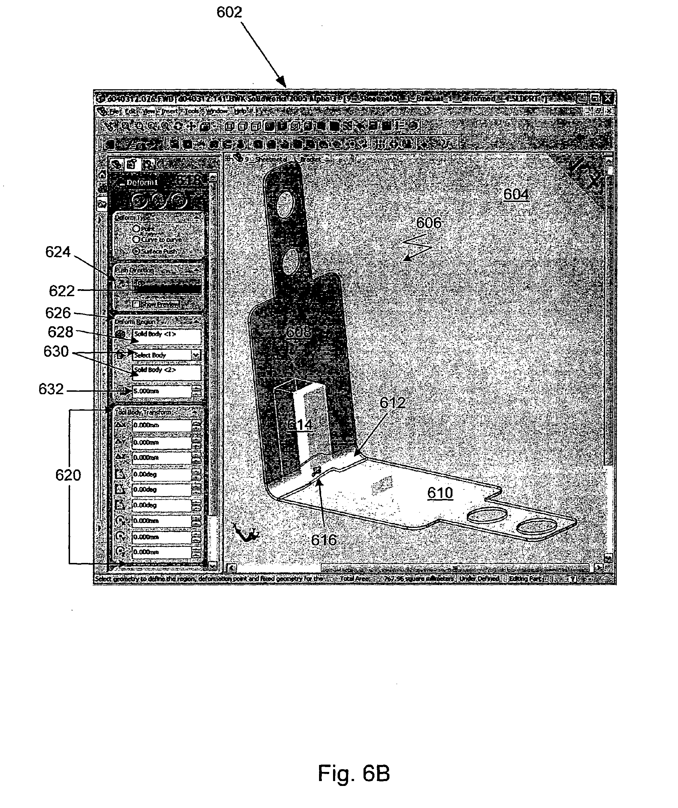

FIG. 6B shows the bracket 606 and an L-shaped tool body 614. The L-shaped tool body 614 was designed with the intention of being used to deform the bracket 606. As shown in FIG. 6B, the L-shaped tool body 614 is a basic shape having planar faces, which may have been created by extruding a hexagonal sketch entity. In FIG. 6B, the L-shaped tool body 614 is positioned with respect to the bracket 606 at the location where the L-shaped tool body 614 is intended to cause the desired deformation. However, the process of moving the L-shaped tool body 614 may also be interactive. Also shown in FIG. 6B is an arrow 616 that indicates the push direction.

A panel 618 containing group boxes to contain user interface tools enables the designer to interact with the modeling system to control the deformation. As shown in FIG. 6B, the panel 618 contains combination boxes 620 that may be used to transform the tool body 614. The combination boxes 620 can be utilized to initiate an instruction to the CAD system that causes the translation of the tool body 614 in the X, Y, or Z direction by a specific distance expressed in millimeters, that causes an X, Y, or Z rotation of the tool body 614 by a specific amount of degrees, or that causes the center of rotation of the tool body 614 to change by a specific distance in the X, Y, or Z direction expressed in millimeters. In addition to translating and rotating the tool body using the combination boxes 620, the tool body may be transformed in the modeling portion 604 using a pointing device (e.g., by dragging and rotating the tool body using a mouse.)

Panel 618 also contains a selection box 622 to specify the push direction. The designer can select a face displayed in the modeling portion 604, to insert the name of the face in the selection box 622. The default push direction is specified as a normal to the selected face, but the designer can override the default by specifying any desirable push direction. The arrow button 624 enables the designer to specify the side of the face from which the push direction will extend.

The deform region group box 626 contains a user-interface control 628 that display the names of faces and bodies in a deformation region. One or more individual faces or one or more bodies may be specified as the region in which a deformation will be applied. The faces and bodies may be specified via selection from the modeling portion 604. Also included in the deform region group box 626 are tool body controls 630, which include a drop-down menu and selection box. The drop-down menu allows the designer to choose a tool body from a library of primitive tool bodies and a library of tool bodies stored in the CAD modeling system by the designer. The selection box in the deform region group box 626 enables selection of tool bodies from the modeling portion 604. Additionally, the smoothness parameter can be specified in the deform region combination box 632.

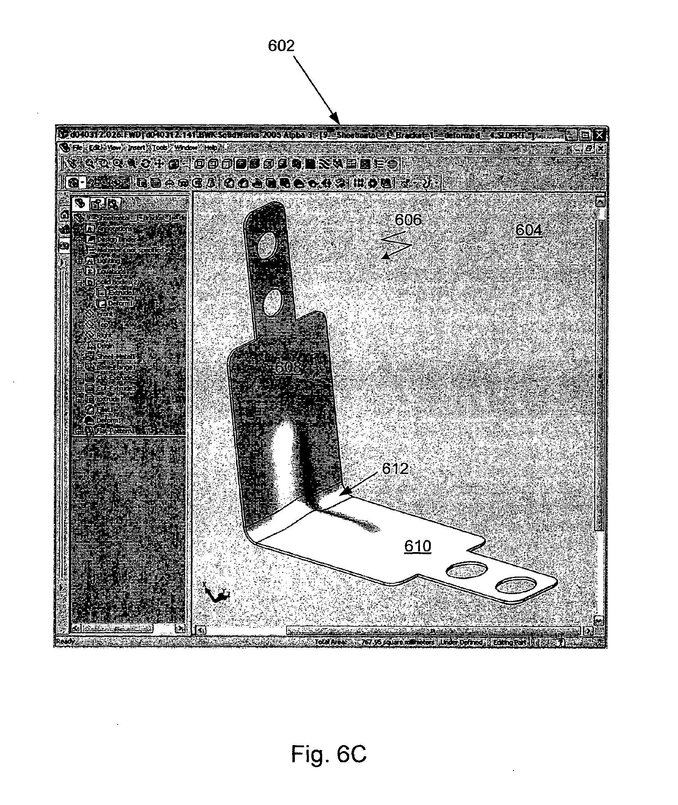

Referring now to FIG. 6C, the bracket 606 has been deformed by the tool body 614 (no longer shown). The vertical side 608, the horizontal side 610, and the bend 612 have been deformed. After the deformation is complete, all deformed faces, including those that are used in the construction of the vertical side 608, the horizontal side 610, and the bend 612 may be stored in a data structure as NURBS surfaces. The vertical side 608 and the horizontal side 610 remain tangent to the bend 612.

Those of ordinary skill in the art will appreciate that the present invention can be used for numerous purposes. One such purpose is package design. In such a design application, the designer does not need to create a tool specifically for deformation purposes. Rather, a model of an object to be packaged may be used as a deformation tool and the model may be constructed from one or more tool bodies.

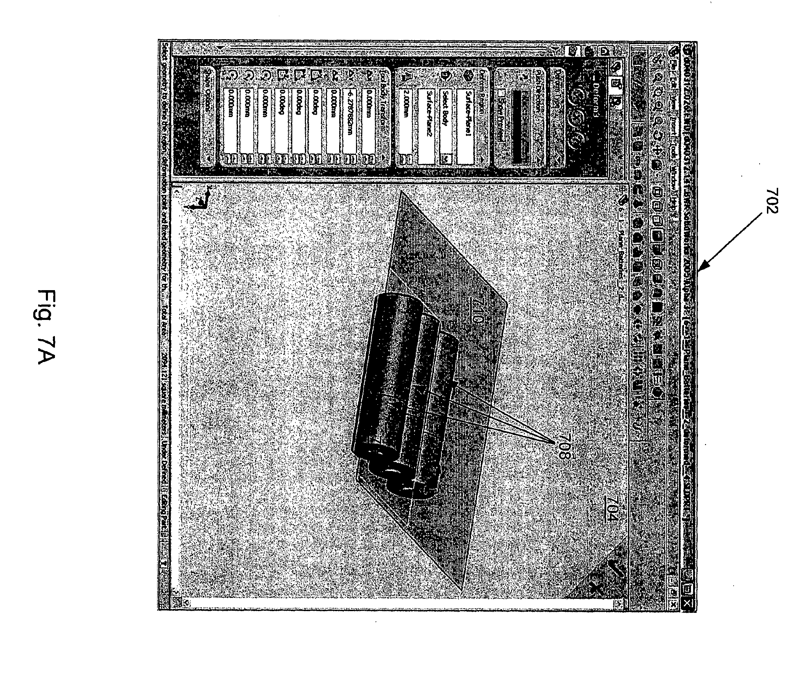

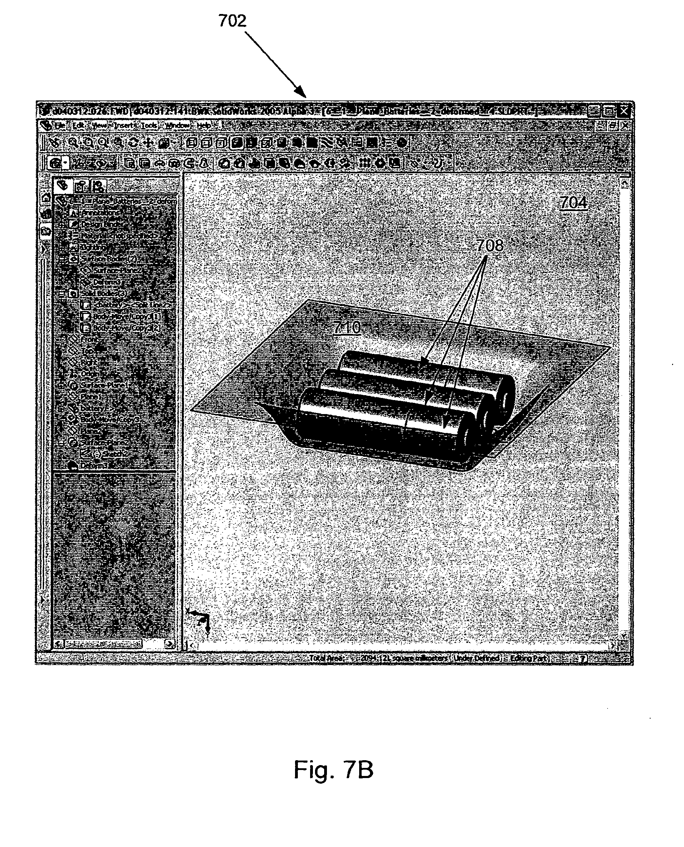

FIGS. 7A and 7B illustrate a window 702 having a modeling area 704 in which a model of a set of batteries is displayed. The model of the batteries is being used as a deformation tool 708 to create a package for the set of batteries. As shown in FIGS. 7A and 7B, the deformation tool 708 consists of three bodies.

The target body 710 is a model of a sheet of packaging material, and initially, in FIG. 7A, the target body 710 is a planar analytical surface. FIG. 7B shows the target body 710 after being deformed by the deformation tool 708. As shown, the target body 710 is deformed in an appropriate way and thereby the target body 710 becomes a useful three-dimensional model that may be used to manufacture a package for the set of batteries.

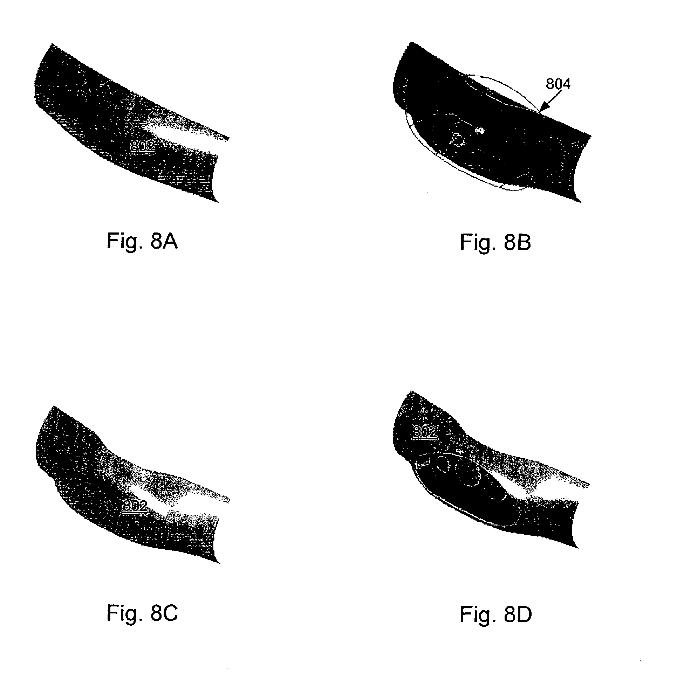

Referring now to FIGS. 8A through 8D, the present invention can also deform a free-form surface. In FIG. 8A, a lofted surface is shown and is the target body 802. In addition to the target body 802, FIG. 8B shows a wire-frame representation of a tool body 804. FIG. 8C shows the target body 802 after the deformation process completes. A trim operation may be applied to the deformed target body 802 to create a model of an object, such as a dashboard, as shown in FIG. 8D.

The present invention offers several advantages to users of 3D CAD systems. One advantage is that a single procedure can simultaneously deform multiple bodies, each of them consisting of many surfaces. Another advantage is that a designer can efficiently control the final shape of one or more target bodies because the designer can use simple easily designed tool bodies or a complex deformation tool that can consist of numerous curve, solid, and surface bodies to create complex deformed shapes.

Another advantage of the present invention is the ability to preserve the topology of the target bodies and the smoothness between adjacent surfaces of the target bodies. The present invention does not divide the surfaces of the target bodies into one or more bodies and does not add any edges to nor remove any edges from the target bodies. Furthermore, original surfaces of a target body that were tangentially adjacent or curvature continuous adjacent remain so after the deformation.

The embodiment described herein describes a CAD modeling system used by designers. By way of non-limiting example, practical design uses of the present invention include free-form surface design, plastic design, consumer products design, packaging design, sheet metal design, tool design, and automobile styling. However, other computer applications can attain enhanced capabilities from the present invention and users of those other systems can benefit from the improved ease of use of such systems.

FIG. 9 shows a computerized modeling system 900 in which the present invention may be implemented. The computerized modeling system 900 includes a CPU 902, a CRT 904, a keyboard input device 906, a mouse input device 908, and a storage device 910. The CPU 902, CRT 904, keyboard 906, mouse 908, and storage device 910 can include commonly available computer hardware devices. For example, the CPU 902 can include a Pentium-based processor. The mouse 908 may have conventional left and right buttons that the user may press to issue a command to a software program being executed by the CPU 902. Other appropriate computer hardware platforms are suitable as is apparent from the foregoing discussion. Such computer hardware platforms are preferably capable of operating the Microsoft Windows NT, Windows 98, Windows 2000, Windows XP, Windows ME, UNIX, Linux, or MAC OS operating systems.

Additional computer processing units and hardware devices (e.g., video, numerical control, and printer devices) may be included in the computerized modeling system 900. Furthermore, the computerized modeling system 900 may include network hardware and software thereby enabling communication to a hardware platform 912 that includes a CPU and a storage system, among other computer components.

Computer-aided design modeling software may be stored on the storage device 910 and is loaded into and executed by the CPU 902. The modeling software allows a designer to create and modify a 3D model and implements aspects of the invention described herein. The CPU 902 uses the CRT 904 to display a 3D model and other aspects thereof as described later in more detail. Using the keyboard 906 and the mouse 908, the designer can enter and modify data associated with the 3D model. The CPU 902 accepts and processes input from the keyboard 906 and mouse 908. The CPU 902 processes the input along with the data associated with the 3D model and makes corresponding and appropriate changes to that which is displayed on the CRT 904 as commanded by the modeling software. Furthermore, the modeling software may allow for relationships that parametrically constrain the definitions of one or more bodies or features therein with respect to one another. If a parametrically constrained relationship exists between two features, a geometric modification to one feature may cause a geometric modification in the other feature.

The invention may be implemented in digital electronic circuitry, or in computer hardware, firmware, software, or in combinations thereof. Apparatus of the invention may be implemented in a computer program product tangibly embodied in a machine-readable storage device for execution by a programmable processor; and method steps of the invention may be performed by a programmable processor executing a program of instructions to perform functions of the invention by operating on input data and generating output. The invention may advantageously be implemented in one or more computer programs that are executable on a programmable system including at least one programmable processor coupled to receive data and instructions from, and to transmit data and instructions to, a data storage system, at least one input device, and at least one output device. Each computer program may be implemented in a high-level procedural or object-oriented programming language, or in assembly or machine language if desired; and in any case, the language may be a compiled or interpreted language. Suitable processors include, by way of non-limiting example, both general and special purpose microprocessors. Generally, a processor will receive instructions and data from a read-only memory and/or a random access memory. Storage devices suitable for tangibly embodying computer program instructions and data include all forms of non-volatile memory, including by way of example semiconductor memory devices, such as EPROM, EEPROM, and flash memory devices; magnetic disks such as internal hard disks and removable disks; magneto-optical disks; and CD-ROM disks. Any of the foregoing may be supplemented by, or incorporated in, custom-designed ASICs (application-specific integrated circuits).

A number of embodiments of the present invention have been described. Nevertheless, it will be understood that various modifications may be made without departing from the spirit and scope of the invention. For example, implementations may change the order in which operations are performed, for instance, the loop formed by steps 306, 308, and 312 shown in FIG. 3 may be changed to a loop formed by steps 308 and 312 (i.e., the push direction and smoothness parameter is only specified once during procedure 300). Furthermore, depending on the needs of an implementation, particular operations described herein may be implemented as a combined operation, eliminated, added to, or otherwise rearranged. Accordingly, other embodiments are within the scope of the following claims.

## Claims

1. A computer-implemented method for deforming a three-dimensional target model using a three-dimensional tool model to cause a change of shape of the target model, the method comprising:
selecting the three-dimensional tool model, the tool model representing an archetype of a shape to impress upon the three-dimensional target model; and
deforming the target model in accordance with a surface deformation procedure that produces a smoothed shape of the tool model in a region of the target model.

2. The method of claim 1, wherein deforming in accordance with a surface deformation procedure comprises:
indicating a push direction for detecting a plurality of extreme geometric values;
examining a plurality of geometric values utilized to construct the tool model and a plurality of geometric values utilized to construct the target model;
generating the plurality of extreme geometric values wherein each one of the extreme geometric values is one of the plurality of geometric values utilized to construct the tool model or one of the plurality of geometric values utilized to construct the target model, whichever represents a point furthest along an axis extending in the push direction;
constructing a surface of extreme values wherein the surface of extreme values is comprised of the plurality of extreme geometric values; and
smoothing the surface of extreme values to create a smoothed surface.

3. The method of claim 1, wherein the target model has a same number of faces and edges before and after the deforming.

4. The method of claim 3, wherein smooth edges remain smooth and sharp edges remain sharp.

5. The computer-implemented method of claim 2, further comprising specifying a smoothness value, the smoothness value specifying a size of a region of the surface of extreme values for consideration by a smoothing operation.

6. The computer-implemented method of claim 5, wherein the smoothness value is one of a default value and a user-specified value.

7. The computer-implemented method of claim 2, further comprising converting the smoothed surface to a non-uniform rational b-spline formulation.

8. The computer-implemented method of claim 1, wherein the target model is comprised of at least one of a curve body, a solid body, and a surface body.

9. The computer-implemented method of claim 1, wherein the tool model is comprised of at least one of a curve body, a solid body, and surface body.

10. The computer-implemented method of claim 2, further comprising applying a transformation to the tool model to move the tool model in a tool model direction.

11. The computer-implemented method of claim 10, further comprising:
interactively receiving user input;
determining the transformation to apply to the tool model in accordance with the user input; and
displaying a current view of the three-dimensional target model while deformation is shown as the transformation is applied to the tool model.

12. The computer-implemented method of claim 10, wherein the push direction is defined as the tool model direction.

13. The computer-implemented method of claim 10, wherein the push direction is independent of the tool model direction.

14. The computer-implemented method of claim 2, wherein the push direction is one of a default direction and a user-specified direction.

15. A computer-implemented method for modifying a three-dimensional target body using a three-dimensional tool body, the method comprising:
storing a first plurality of data representing the three-dimensional target body, wherein:
the first plurality of data is utilized to construct the target body, and
the target body is comprised of at least one curve body, surface body, or solid body;
storing a second plurality of data representing the three-dimensional tool body, the second plurality of data utilized to construct the tool body; and
deforming the target body utilizing a surface deformation procedure to produce a smoothed shape of the tool body in a region of the target body.

16. The computer-implemented method of claim 15, wherein deforming the target body in accordance with a surface deformation procedure comprises:
designating a direction in which to deform the target body, the direction utilized to create a plurality of rays extending in the direction; and
determining a plurality of extreme points wherein:
each one of the plurality of extreme points is one of a tool body geometric point stored with the first plurality of data and a target body geometric point stored with the second plurality of data; and
each one of the plurality of extreme points is positioned farthest on one of the plurality of rays; and
smoothing the plurality of extreme points using a smoothing technique to create one
of a curve representation or a surface representation of smoothed extreme points.

17. The computer-implemented method of claim 16, wherein the representation of smoothed extreme points replaces at least one of a curve body, a surface body, and a solid body of the target body.

18. The computer-implemented method of claim 16, further comprising specifying a smoothness value for determining a similarity between the target body and the representation of smoothed extreme points.

19. The computer-implemented method of claim 16, wherein the smoothness value determines a number of rays created in the plurality of rays.

20. The computer-implemented method of claim 16, further comprising converting the representation of smoothed extreme points to a non-uniform rational b-spline formulation.

21. The computer-implemented method of claim 16, further comprising moving the tool body relative to the target body in a tool body direction.

22. The computer-implemented method of claim 21, wherein the direction in which to deform the target body is the tool body direction.

23. A digital computer comprising:
a memory, data stored in the memory, and control information stored in the memory; and
a data processor for processing the data in accordance with the control information;
wherein,
the control information is arranged to:
process a first data structure defining a model of a three-dimensional object, the model comprised of a plurality of first geometric values utilized to construct the model,
process a second data structure defining a three-dimensional tool body, the tool body comprised of a plurality of second geometric values used to construct the tool body,
generate a third data structure defining a plurality of rays extending in an identical direction,
determine a plurality of extreme values by detecting a farthest point on each one of the plurality of rays occupied by one of the plurality of first geometric values and the plurality of second geometric values, and
construct one or more smoothed bodies by applying a smoothing operation to the plurality of extreme values.

24. The digital computer of claim 23, wherein the control information is further arranged to incorporate the one or more smoothed bodies into the first data structure defining the model.

25. The digital computer of claim 23, wherein the control information is further arranged to define a smoothness value, the smoothness value utilized in specifying an amount of extreme values in the plurality of extreme values for the smoothing operation.

26. The digital computer of claim 25, wherein the smoothness value determines a quantity of rays defined.

27. The digital computer of claim 23, wherein the control information is further arranged to convert the one or more smoothed bodies to a non-uniform rational b-spline formulation.

28. The digital computer of claim 23, wherein the model is comprised of one or more than one curve body, solid body, and surface body.

29. The digital computer of claim 23, wherein the control information is further arranged to re-position the tool body by applying a transformation matrix to the tool body to move the tool body in a tool direction.

30. The digital computer of claim 29, wherein the identical direction of the plurality of rays is the tool model direction.

31. The digital computer of claim 23, wherein user input determines the identical direction of the plurality of rays.
